Europäisches Patentamt

European Patent Office

Office européen des brevets

(11) Veröffentlichungsnummer: **0 445 335 A1**

## EUROPÄISCHE PATENTANMELDUNG

(21) Anmeldenummer: 90104482.6

(22) Anmeldetag: 09.03.90

(51) Int. Cl.⁵: **H03H  17/06,** H03H 17/02

(43) Veröffentlichungstag der Anmeldung:
**11.09.91 Patentblatt  91/37**

(84) Benannte Vertragsstaaten:
**DE**

(71) Anmelder: **DEUTSCHE ITT INDUSTRIES GMBH**
**Hans-Bunte-Strasse 19 Postfach 840**
**W-7800 Freiburg i.Br.(DE)**

(72) Erfinder: **Désor, Hans-Jürgen, Dipl.-Ing.**
**Sonnenwiese 18**
**W-7803 Gundelfingen(DE)**
Erfinder: **Sieben, Ulrich K., Dr.**
**Kronengasse 7**
**W-7801 Reute(DE)**

(54) **Vorrichtung und Verfahren zur Erhöhung der Taktrate eines FIR-Filters.**

(57) Beschrieben wird eine Vorrichtung zur Erhöhung der Taktrate eines FIR-Filters. Dabei ist vorgesehen, daß ein Demultiplexer (10) des Multiplexgrades N vorgesehen ist, dessen Ausgänge über erste Datenbusse ($DF_1$-$DF_N$) mit einer Filteranordnung (20) verbunden sind, die identisch aufgebaute Filtergruppen ($FG_1$-$FG_N$) aufweist, wobei jede Filtergruppe ($FG_1$-$FG_N$) aus identisch aufgebauten Teilfiltern ($TF_1$-$TF_N$) besteht und jedes Teilfilter ($TF_1$-$TF_N$) jeder Filtergruppe ($FG_1$-$FG_N$) über je einen zweiten Datenbus ($DA_1$-$DA_N$) mit einem zugeordneten Addierer ($A_1$-$A_N$) verbunden ist, und daß ein Multiplexer (30) des Multiplexergrades N vorgesehen ist, dessen Eingänge über dritte Datenbusse ($DM_1$-$DM_N$) mit den Addierern ($A_1$-$A_N$) verbunden sind.

FIG.1

EP 0 445 335 A1

Die Erfindung betrifft eine Vorrichtung und ein Verfahren zur Erhöhung der Taktrate eines FIR-Filters.

FIR-Filter -auch nichtrekursive Filter oder Transversalfilter genannt- sind bekannt (FIR = Finite Impulse Response). Eine charakteristische Kenngröße eines derartigen digitalen Filters wird durch die Übertragungsfunktion repräsentiert, die eine eindeutige Zuordnung eines an einem Eingang des FIR-Filters anliegenden Eingangssignal zu einem exakt definierten Ausgangssignal bewirkt. Die zur hardwaremäßigen Realisierung einer vorgegebenen Übertragungsfunktion benötigte Anzahl von Verzögerungsleitungen, Multiplizierer und Addierer beschränkt aufgrund der maximal erreichbaren Verarbeitungsgeschwindigkeit der einzelnen Komponenten die Anzahl der Signalimpulse, welche pro Zeiteinheit verarbeitet werden können. Diese maximale Filter-Taktrate stellt also einen oberen Grenzwert für die zeitliche Abfolge der am Eingang des FIR-Filters anliegenden Eingangssignale dar. Diese darf nicht überschritten werden, wenn eine einwandfreie Funktion des Digitalfilters gewährleistet sein soll. Eine hardwaremäßige Beschleunigung der Verarbeitungsgeschwindigkeit der einzelnen Komponenten ist nur in gewissen Grenzen möglich und erhöht den Aufwand und die Herstellungskosten beträchtlich.

Zur Vermeidung dieses Nachteils stellt sich die Erfindung die Aufgabe, ein Verfahren und eine Vorrichtung, insbesondere für monolithisch integrierte Schaltungen, zu schaffen, die in besonders einfacher Art und Weise die Erhöhung der Taktrate eines FIR-Filters ermöglicht. Die Realisierung des erfindungsgemäßen FIR-Filters soll durch den Einsatz konventioneller Verzögerungsleitungen, Addierer und Multiplizierer erfolgen.

Die Aufgabe wird dadurch gelöst, daß ein Demultiplexer des Multiplexgrades N vorgesehen ist, dessen Ausgänge über erste Datenbusse mit einer Filteranordnung verbunden sind, die identisch aufgebaute Filtergruppen aufweist, wobei jede Filtergruppe aus identisch aufgebauten Teilfiltern besteht und jedes Teilfilter jeder Filtergruppe über je einen zweiten Datenbus mit einem zugeordneten Addierer verbunden ist, und daß ein Multiplexers des Multiplexgrades N vorgesehen ist, dessen Eingänge über dritte Datenbusse mit den Addierern verbunden sind.

Die erfindungsgemäße Vorrichtung besitzt den Vorteil, daß es die Aufspaltung des Eingangssignals der Taktrate $f_1$ in eine dem Multiplexgrad N des Demultiplexers entsprechende Anzahl von Teilsignalen der wesentlich kleineren Taktrate $f_2$ erlaubt, die eigentliche Filterung des Eingangssignals in einer Filteranordnung vorzunehmen, deren maximal zulässige Filter-Taktrate deutlich unter der Taktrate des Eingangssignals liegt. Dies bewirkt, daß die Realisierung des erfindungsgemäßen FIR-Filters mit konventioneller Auslegung in konventioneller Technik möglich ist. Dadurch ist eine besonders einfache und wirtschaftliche Bauweise gewährleistet.

Eine vorteilhafte Weiterbildung der Erfindung sieht vor, daß die erfindungsgemäßen FIR-Filter kaskadierbar sind. Dies ermöglicht es in besonders einfacher Art und Weise, FIR-Filter beliebiger Länge zu realisieren.

Weitere vorteilhafte Weiterbildungen ergeben sich aus den Unteransprüchen.

Weitere Einzelheiten der Erfindung sind den nachfolgenden Ausführungsbeispielen zu entnehmen, die im folgenden anhand der Zeichnungen eingehend erläutert werden. Es zeigen:

Figur 1 ein erstes Ausführungsbeispiel,
Figur 2 ein zweites Ausführungsbeispiel,
Figur 3 ein Teilfilter,
Figur 4 ein drittes Ausführungsbeispiel.

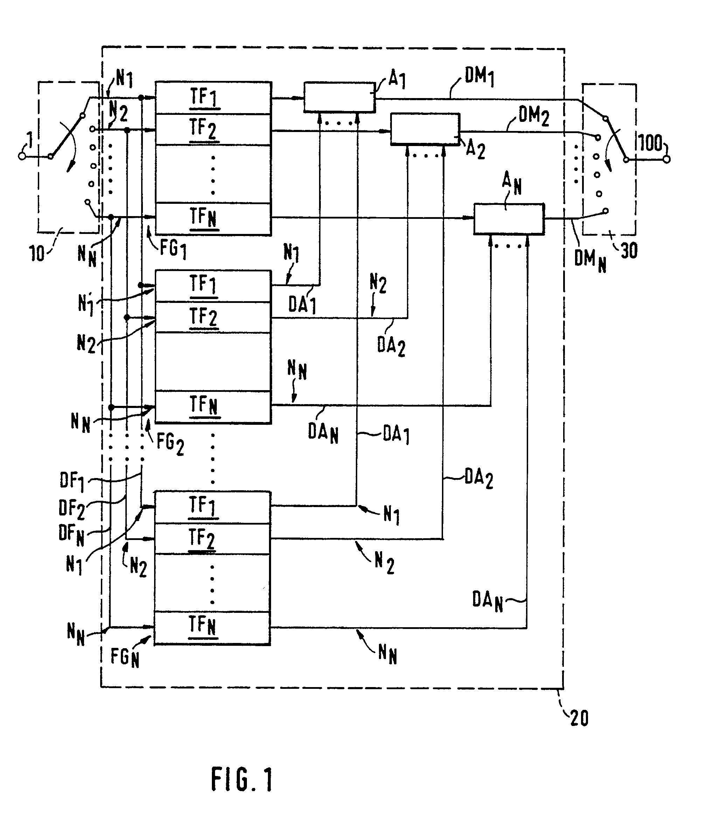

Das Verfahren zur Erhöhung der Taktrate wird anhand des in Fig. 1 schematisch dargestellten Aufbaus der entsprechenden Vorrichtung beschrieben. Diese Figur zeigt einen Demultiplexer 10 und einen Multiplexer 30, zwischen denen eine Filteranordnung 20 (in Fig. 1 durch das strichlierte Rechteck repräsentiert) geschaltet ist. Der Demultiplexer 10 und der Multiplexer 30 unterscheiden sich von der Filteranordnung 20 wesentlich im Hinblick auf ihre Taktrate: Diese ist beim Demultiplexer 10 und beim Multiplexer 30 derart bemessen, daß diese Bauteile pro Zeiteinheit $f_1$ Signalimpulse verarbeiten können. Die Filteranordnung 20 hingegen arbeitet mit einer Filter-Taktrate $f_2$, die um den Faktor N kleiner als die Taktrate $f_1$ des Demultiplexers 10 ist. In der Filteranordnung 20 können also höchstens $f_2$ Signalimpulse pro Zeiteinheit verarbeitet werden.

Um die am Eingang 1 der Vorrichtung mit einer Taktrate $f_1$ auftretenden Signalimpulse durch die mit der um den Faktor N kleineren Filter-Taktrate $f_2$ arbeitenden Filteranordnung 20 verarbeiten zu können ist vorgesehen, daß im Demultiplexer 10 das Eingangssignal in N Teilsignale, $N_1$, $N_2$ ... $N_N$ aufgespalten wird. Dies bewirkt, daß jedes der am Ausgang des Demultiplexers 10 auftretenden Teilsignale $N_1$-$N_N$ eine Taktrate aufweist, die kleiner oder höchstens gleich der Filter-Taktrate $f_2$ der Filteranordnung 20 ist.

Die über erste Datenbusse $DF_1$-$DF_N$ mit dem Demultiplexer 10 verbundene Filteranordnung 20 weist N identisch aufgebaute Filtergruppen $FG_1$-$FG_N$ auf, die ihrerseits aus N identisch aufgebauten Teilfiltern $TF_1$-$TF_N$ bestehen. Hierbei ist vorgesehen, daß das Teilsignal $N_1$ über den ersten Datenbus $DF_1$ zu dem Eingang jedes Teilfilters $TF_1$ aller Filtergruppen $FG_1$-$FG_N$ und die anderen Teilsignale $N_2$-$N_N$ über die entsprechenden anderen ersten

Datenbusse $DF_2$-$DF_N$ an die entsprechenden Teilfilter $TF_2$-$TF_N$ aller Filtergruppen $FG_1$-$FG_N$ geleitet werden.

Die identisch aufgebauten Teilfilter $TF_1$-$TF_N$ werden durch bekannte FIR-Filter realisiert, die eine Filter-Taktrate aufweisen, welche die Verarbeitung von $f_2$ Signalimpulsen pro Zeiteinheit erlaubt. Jedes Teilfilter besteht in bekannter Art und Weise aus einer Anzahl Verzögerungsleitungen, Multiplizierern und Addierern, die gemäß der gewählten Filterarchitektur -z.B. einer kanonischen Direktstruktur oder einer transponierten Direktstruktur- miteinander verknüpft sind. Wichtig ist nur, daß die Übertragungsfunktion jedes einzelnen Filters -ihre Teilübertragungsfunktion im Hinblick auf die Übertragungsfunktion des zu realisierenden Gesamtfilters- derart festgelegt ist, daß die Summe der Teilübertragungsfunktionen der Teilfilter $TF_1$-$TF_N$, die ein Teilsignal $N_1$-$N_N$ jeweils durchläuft, die Übertragungsfunktion des zu realisierenden FIR-Filters ergibt.

Diese Aufspaltung der Übertragungsfunktion des zu realisierenden FIR-Filters in die Teilübertragungsfunktionen der einzelnen Teilfilter $TF_1$-$TF_N$ bewirkt in besonders vorteilhafter Weise, daß die mit der Filteranordnung - entsprechend der gewählten Filterarchitektur der Teilfilter - korrelierte Länge der Teilfilter reduziert wird. Dies vereinfacht den Aufbau der Teilfilter beträchtlich und erlaubt eine Verringerung der Filter-Taktrate $f_2$ der Teilfilter $TF_1$-$TF_N$ gegenüber der Filter-Taktrate $f_1$ des FIR-Ausgangsfilters entsprechend der Anzahl der verwendeten Teilfilter.

Desweiteren weist die Filteranordnung 20 Addierer $A_1$-$A_N$ auf, die über zweite Datenbusse $DA_1$-$DA_N$ mit den Ausgängen der Teilfilter $TF_1$-$TF_N$ der Filtergruppen $FG_1$-$FG_N$ wie folgt verbunden sind: Die Teilfilter $TF_1$ jeder Filtergruppe $FG_1$-$FG_N$ sind mit dem Addierer $A_1$, die Teilfilter $TF_2$ jeder Filtergruppe $FG_1$-$FG_N$ sind mit dem Addierer $A_2$ verbunden, etc. Jeder Addierer $A_1$-$A_N$ ist über je einen dritten Datenbus $DM_1$-$DM_N$ mit einem zugeordneten Eingang des Multiplexers 30 verbunden.

Die Funktionsweise der Vorrichtung ist nun wie folgt: Die am Eingang 1 anliegenden Eingangssignale der Taktrate $f_1$ werden im Demultiplexer 10 in N Teilsignale $N_1$-$N_N$ mit der gegenüber der Taktrate $f_1$ um den Faktor N kleineren Taktrate $f_2$ aufgespalten. Diese werden über die ersten Datenbusse $DF_1$-$DF_N$ zu den entsprechenden Teilfiltern $TF_1$-$TF_N$ der einzelnen Filtergruppen $FG_1$-$FG_N$ geleitet. Diese N Teilsignale $N_1$-$N_N$ durchlaufen parallel die N mal N identisch aufgebauten Teilfilter $TF_1$-$TF_N$ der Filtergruppen $FG_1$-$FG_N$, werden darin entsprechend der Übertragungsfunktion des jeweiligen Teilfilters verarbeitet und gelangen über die zweiten Datenbusse $DA_1$-$DA_N$ schließlich zu ihrem zugeordneten Addierer $A_1$-$A_N$. In diesen werden die eintreffenden Signale zu Teilsummen addiert und über die dritten Datenbusse $DM_1$-$DM_N$ den korrespondierenden Eingängen des Multiplexers 30 zugeführt. In diesem wird aus den in den Addierern $A_1$-$A_N$ gebildeten N Teilsummen durch einen zyklischen Abgriff mit der Taktrate $f_1$ ein Ausgangssignal gebildet. Am Ausgang 100 der Vorrichtung liegt dann das Ausgangssignal an, welches wiederum eine Taktrate von $f_1$ aufweist.

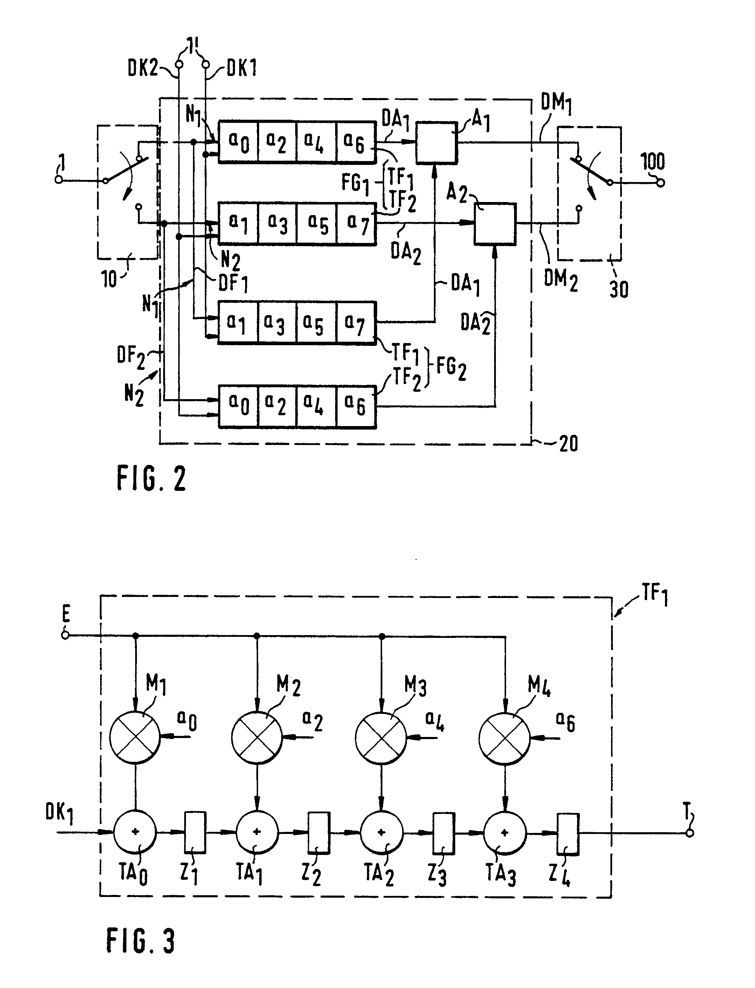

In Fig. 2 ist anhand eines zweiten Ausführungsbeispiels ein einfacher Anwendungsfall dargestellt. Es soll ein FIR-Filter realisiert werden, dessen Übertragungsfunktion durch die ersten acht Terme der die Filtercharakteristik festlegenden Laurentreihe (z-Transformation) repräsentiert wird. Die entsprechenden Filterkoeffizienten werden mit $a_0$, $a_1$ ... $a_7$ bezeichnet.

Das am Eingang 1 anliegende, aus $f_1$ Signalimpulsen pro Sekunde bestehende Eingangssignal wird im Demultiplexer 10 in zwei Teilsignale $N_1$ und $N_2$ aufgespalten. Jedes der Teilsignale $N_1$ und $N_2$ weist eine Taktrate $f_2$ auf, die aufgrund des Multiplexgrades N = 2 nur die Hälfte der Taktrate $f_1$ der Eingangssignale beträgt. Demgemäß kann die Filteranordnung 20 derart ausgelegt sein, daß sie -anstelle der am Eingang 1 auftretenden Signalfolge mit $f_1$ Signalimpulsen pro Sekunde- nur $f_2$ Signalimpulse pro Sekunde verarbeiten muß, aber dies in zwei parallelen Filtergruppen $FG_1$, $FG_2$. Dies erlaubt vorteilhafterweise eine entsprechend langsamere Signalverarbeitung und damit eine entsprechend einfachere Ausführung der Filteranordnung 20. Das Teilsignal $N_1$ wird dem Teilfilter $TF_1$ der ersten Filtergruppe $FG_1$ und dem Teilfilter $TF_1$ der zweiten Filtergruppe $FG_2$ zugeführt. Analog liegt das Teilsignal $N_2$ am zweiten Teilfilter $TF_2$ der ersten und der zweiten Filtergruppen $FG_1$ und $FG_2$ an. Hierbei wird angenommen, daß die Teilfilter $TF_1$ und $TF_2$ der Filtergruppen $FG_1$ und $FG_2$ die Teilfilter-Architektur einer transponierten Direktstruktur aufweisen.

Ein derartiges Teilfilter $TF_1$ ist in Fig. 3 dargestellt. Es besteht aus vier Verzögerungsleitungen $Z_1$-$Z_4$, vier Multiplizierern $M_1$-$M_4$ und aus drei Addierern $TA_1$-$TA_3$. Die am Eingang E anliegenden Signalimpulse werden in den entsprechenden Multiplizierern $M_1$-$M_4$ mit der zugeordneten Filterkonstante $a_0$-$a_6$ multipliziert. Am Ausgang T liegt als Ausgangssignal das entsprechend der Filterkonstanten der Teilübertragungsfunktion modifizierte Eingangssignal an. Die Belegung der einzelnen Multiplizierer $M_1$-$M_4$ mit den Filterkonstanten $a_0$, $a_2$, $a_4$, $a_6$ entspricht der Teilübertragungsfunktion des ersten Teilfilters $TF_1$ der ersten Filtergruppe $FG_1$. Die der Realisierung der drei weiteren Teilfilter des zweiten Ausführungsbeispiel ist aus der in Fig. 2 dargestellten Belegung mit den korrespondierenden Filterkonstanten ersichtlich.

Nach dem Durchlaufen der entsprechenden Teilfilter werden die Teilsignale $N_1$ und $N_2$ in den Addierern $A_1$ und $A_2$ entsprechend aufsummiert und zum Multiplexer 30 geleitet. Aus den beiden Teilsummen wird durch einen zyklischen Abgriff mit einer zweifachen Taktrate $f_2$ der Filteranordnung 20 - also mit der Taktrate $f_1$ der Eingangssignale - das Ausgangssignal gebildet.

In Fig. 2 sind außerdem zwei weitere Datenbusse $DK_1$ und $DK_2$ dargestellt, die von einem weiteren Eingang 1' des FIR-Filters direkt zu den Addierern $TA_0$ der Filtergruppen $FG_1$ und $FG_2$ - (siehe Fig.3) geführt sind. Diese Datenbusse $DK_1$ und $DK_2$ dienen der Kaskadierung der beschriebenen Vorrichtung mit einem weiteren evt. auch externen Digitalfilter. Dies ermöglicht es, eine beliebige Anzahl entsprechend aufgebauter Digitalfilter hintereinander zu schalten.

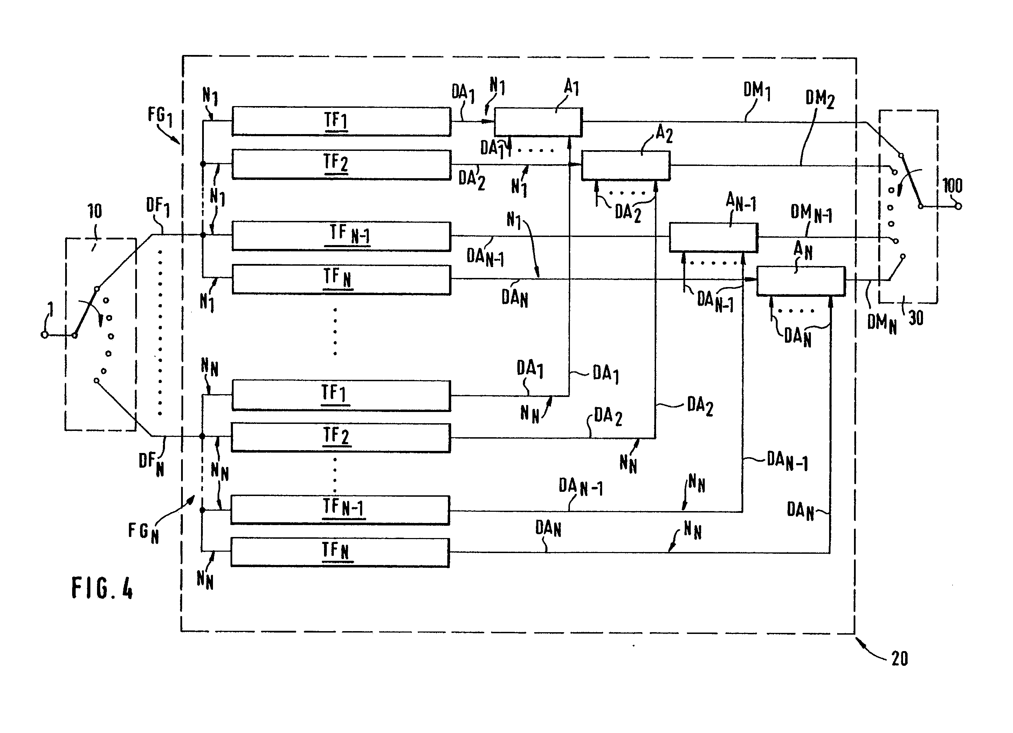

Die im ersten und im zweiten Ausführungsbeispiel beschriebene Aufteilung der Teilfilter $TF_1$-$TF_N$ auf die Filtergruppen $FG_1$-$FG_N$ stellt nicht die einzig mögliche Architektur der Filteranordnung 20 dar. Es kann auch vorgesehen sein, daß die erste Filtergruppe $FG_1$ bzw. die restlichen Filtergruppen $FG_2$-$FG_N$ alle Teilfilter $TF_1$-$TF_N$ enthält, die vom ersten Teilsignal $N_1$ bzw. von je einem Teilsignal der restlichen Teilsignale $N_2$-$N_N$ durchlaufen werden. Eine derartige Architektur der Filteranordnung 20 ist in dem in der Fig. 4 dargestellten dritten Ausführungsbeispiel realisiert. Die Funktionsweise dieser Vorrichtung ist dem Fachmann aus den weiter oben angeführten Erläuterungen ersichtlich und wird deshalb an dieser Stelle nicht mehr explizit angeführt.

Desweiteren sind noch eine Vielzahl von anderen Realisierungsmöglichkeiten der Filteranordnung 20 möglich, die für den Fachmann auf der Grundlage der bekannten Methode der Filterstrukturumwandlung durch eine Äquivalenztransformation der die Filterarchitektur charakterisierenden Signalflußmatrix leicht auffindbar sind.

Wichtig hierbei ist, daß das am Eingang des FIR-Filters anliegende Eingangssignal der Taktrate $f_1$ in eine dem Multiplexgrad N entsprechende Anzahl von Teilsignalen $N_1$-$N_N$ der Taktrate $f_2$ aufgespalten wird, und daß jedes der Teilsignale $N_1$-$N_N$ in der Filteranordnung 20 einen Signalweg - z.B. N identisch aufgebaute Teilfilter $TF_1$-$TF_N$ mit unterschiedlichen Teilübertragungsfunktionen - durchläuft, dessen Übertragungsfunktion gleich der Übertragungsfunktion des zu realisierenden Gesamtfilters ist.

**Patentansprüche**

1. Vorrichtung zur Erhöhung der Taktrate eines FIR-Filters, **dadurch gekennzeichnet**, daß ein Demultiplexer (10) des Multiplexgrades N vorgesehen ist, dessen Ausgänge über erste Datenbusse ($DF_1$-$DF_N$) mit einer Filteranordnung (20) verbunden sind, die identisch aufgebaute Filtergruppen ($FG_1$-$FG_N$) aufweist, wobei jede Filtergruppe ($FG_1$-$FG_N$) aus identisch aufgebauten Teilfiltern ($TF_1$-$TF_N$) besteht und jedes Teilfilter ($TF_1$-$TF_N$) jeder Filtergruppe ( $FG_1$-$FG_N$) über je einen zweiten Datenbus ($DA_1$-$DA_N$) mit einem zugeordneten Addierer ($A_1$-$A_N$) verbunden ist, und daß ein Multiplexer (30) des Multiplexergrades N vorgesehen ist, dessen Eingänge über dritte Datenbusse ( $DM_1$-$DM_N$) mit den Addierern ($A_1$-$A_N$) verbunden sind.

2. Vorrichtung nach Anspruch 1, dadurch gekennzeichnet, daß alle Teilfilter ($TF_1$-$TF_N$) einer Filtergruppe ($FG_1$-$FG_N$) über genau einen ersten Datenbus ($DF_1$-$DF_N$) mit einem Ausgang des Demultiplexers (10) verbunden sind.

3. Vorrichtung nach Anspruch 2, dadurch gekennzeichnet, daß jedes einzelne Teilfilter ($TF_1$-$TF_N$) einer Filtergruppe ($FG_1$-$FG_N$) eine Teilübertragungsfunktion aufweist, die von den Teilübertragungsfunktionen der restlichen Teilfilter ($TF_1$-$TF_N$) der gleichen Filtergruppe ($FG_1$-$FG_N$) verschieden ist, und daß die Summe der Teilübertragungsfunktionen der einzelnen Teilfilter ($TF_1$-$TF_N$) einer Filtergruppe ($FG_1$-$FG_N$) die Übertragungsfunktion des zu realisierenden FIR-Filters ergibt.

4. Vorrichtung nach Anspruch 1, dadurch gekennzeichnet, daß jedes Teilfilter ($TF_1$-$TF_N$) einer Filtergruppe ($FG_1$-$FG_N$) über je einen ersten Datenbus ($DF_1$-$DF_N$) mit je einem Ausgang des Demultiplexers (10) verbunden ist.

5. Vorrichtung nach Anspruch 4, dadurch gekennzeichnet, daß jedes einzelne Teilfilter ($TF_1$-$TF_N$) einer Filtergruppe eine Teilübertragungsfunktion aufweist, die von den Teilübertragungsfunktionen der restlichen Teilfilter ($TF_1$-$TF_N$) der gleichen Filtergruppe ($FG_1$-$FG_N$) verschieden ist, und daß die Summe der Teilübertragungsfunktionen einander entsprechender Teilfilter ($TF_1$-$TF_N$) aller Filtergruppen ($FG_1$-$FG_N$) die Übertragungsfunktion des zu realisierenden FIR-Filters ergibt.

6. Vorrichtung nach einem der Ansprüche 1-5, dadurch gekennzeichnet, daß jedes Teilfilter ($TF_1$-$TF_N$) eine transponierte Direktstruktur aufweist.

7. Vorrichtung nach einem der Ansprüche 1-5, dadurch gekennzeichnet, daß jedes Teilfilter

(TF$_1$-TF$_N$) eine kanonische Direktstruktur aufweist.

8. Vorrichtung nach einem der Ansprüche 1-5, dadurch gekennzeichnet, daß die Ordnung eines Teilfilters (TF$_1$-TF$_N$) durch die Ordnung des FIR-Filters und des Multiplexgrades N des Demultiplexers (10) festgelegt ist.

9. Vorrichtung nach einem der Ansprüche 1-5, dadurch gekennzeichnet, daß weitere Datenbusse (DK$_1$,DK$_2$) vorgesehen sind, die einen weiteren Eingang (1') des FIR-Filters mit den zugeordneten Addierern (TA$_0$) der Teilfilter (TF$_1$-TF$_N$) der Filtergruppen (FG$_1$-FG$_N$) verbinden.

10. Verfahren zur Erhöhung der Taktrate eines FIR-Filters, **dadurch gekennzeichnet**, daß ein am Eingang (1) des FIR-Filters anliegendes Eingangssignal mit erster Taktrate f$_1$ in einem Demultiplexer (10) in eine dem Multiplexgrad N entsprechende Anzahl von Teilsignale (N$_1$-N$_N$) mit zweiter Taktrate f$_2$ aufgespalten wird, deren zweite Taktrate f$_2$ um den Multiplexgrad N-mal kleiner als die erste Taktrate f$_1$ der Eingangssignale ist, und daß jedes einzelne Teilsignal (N$_1$-N$_N$) in der Filteranordnung (20) einen Signalweg durchläuft, dessen Übertragungsfunktion gleich der Übertragungsfunktion des zu realisierenden FIR-Filters ist, und daß die Teilsignale (N$_1$-N$_N$) in Addierern (A$_1$-A$_N$) zu Teilsummen aufaddiert werden, die im Multiplexer (30) durch einen zyklischen Abgriff mit der ersten Taktrate f$_1$ zu einem Ausgangssignal addiert werden.

FIG.1

FIG. 2

FIG. 3

7

FIG. 4

# EUROPÄISCHER RECHERCHENBERICHT

## EP 90 10 4482

## EINSCHLÄGIGE DOKUMENTE

| Kategorie | Kennzeichnung des Dokuments mit Angabe, soweit erforderlich, der maßgeblichen Teile | Betrifft Anspruch | KLASSIFIKATION DER ANMELDUNG (Int. Cl.5) |
|---|---|---|---|
| X | PROCEEDINGS: ICASSP'87, 1987 INTERNATIONAL CONFERENCE ON ACOUSTICS, SPEECH, AND SIGNAL PROCESSING, Dallas, 6.-9. April 1987, Seiten 1863-1866; H.K. KWAN et al.: "High speed 1-D FIR digital filtering architectures using polynomial convolution" <br> * Figur 1; Seiten 1863-1864: "1-D finite lenght convolution in polynomial ring" * | 1-5,10 | H 03 H 17/06 <br> H 03 H 17/02 |
| A | ELECTRONICS LETTERS, Band 23, Nr. 15, 16. Juli 1987, Seiten 769-771, Stevenage, GB; D.R. BULL et al.: "Reduced-complexity digital filtering structures using primitive operations" <br> * Das ganze Dokument * | 6 | |

| RECHERCHIERTE SACHGEBIETE (Int. Cl.5) |
|---|
| H 03 H |

Der vorliegende Recherchenbericht wurde für alle Patentansprüche erstellt

| Recherchenort | Abschlußdatum der Recherche | Prüfer |
|---|---|---|
| Den Haag | 12 November 90 | COPPIETERS C. |